# EUROPÄISCHE PATENTSCHRIFT

(11) **EP 2 652 775 B1**
(45) Veröffentlichungstag und Bekanntmachung des Hinweises auf die Patenterteilung: **20.02.2019**
(21) Anmeldenummer: 11797219.0
(22) Anmeldetag: 09.12.2011
(51) Int. Cl.: H01L 21/56, H05K 13/00, H05K 5/06, H05K 1/18, H05K 3/30

(54) **VERFAHREN ZUR HERSTELLUNG EINER ELEKTRONISCHEN BAUGRUPPE MIT FORMKÖRPER**
METHOD FOR PRODUCING AN ELECTRONIC ASSEMBLY HAVING A SHAPED BODY
PROCÉDÉ DE FABRICATION D'UN MODULE ÉLECTRONIQUE AU MOYEN D'UN CORPS MOULÉ

(30) Priorität: 14.12.2010 DE 102010063048
(43) Veröffentlichungstag der Anmeldung: 23.10.2013
(73) Patentinhaber: Robert Bosch GmbH, 70442 Stuttgart (DE)
(72) Erfinder: GRAUF, Gerhard, 72805 Lichtenstein-Unterhausen (DE)
(86) Internationale Anmeldenummer: PCT/EP2011/072355
(87) Internationale Veröffentlichungsnummer: WO 2012/080137

(56) Entgegenhaltungen:
- WO-A1-99/53740
- DE-A1- 19 751 109
- DE-A1-102009 001 373
- DE-A1-102009 026 804
- JP-A- 57 015 444
- US-A1- 2002 063 326
- US-A1- 2006 054 901
- US-A1- 2006 220 202
- US-A1- 2009 045 498

## Beschreibung

### Stand der Technik

Die vorliegende Erfindung betrifft ein Verfahren zur Herstellung einer elektronischen Baugruppe mit Formkörper sowie eine derartige elektronische Baugruppe.

Elektronische Baugruppen mit Formkörper sind bisher derart bekannt, dass ein elektronisches Bauteil, wie beispielsweise eine bestückte Leiterplatte oder Sensoren, auf einem Stanzgitter oder Keramiksubstraten von einem Formkörper aus einem Moldmaterial teilweise oder vollständig umschlossen sind. Bei vollständig umschlossenen elektronischen Baugruppen sind elektrische Kontaktelemente bis zur Außenseite des Formkörpers geführt. Da bei den bekannten elektronischen Baugruppen nur ein einziges Moldmaterial zur Einbettung der elektronischen Bauteile verwendet wird, können diese zwar in einem Schritt relativ schnell hergestellt werden, jedoch können keine Anpassungen an die verschiedenen elektronischen Bauteile, welche beispielsweise unterschiedlich große Wärmemengen erzeugen, gemacht werden. Es wäre daher wünschenswert, ein einfaches und kostengünstiges Verfahren zur Herstellung einer elektronischen Baugruppe sowie eine derartige elektronische Baugruppe bereitzustellen, welche unterschiedlichen Anforderungen von elektronischen Bauteilen entspricht.

Weiterhin weist die DE 197 51109 A1 eine elektrische Schaltung mit einem umgebenden Gehäuse auf, wobei das Gehäuse ein erstes Material sowie wenigstens ein Sekundärmaterial aufweist, wobei das Sekundärmaterial kernartig im Bereich des ersten Materials vorgesehen ist. Weiterhin wird ein Verfahren zum Herstellen dieses Kunststoffverbundkörpers offenbart. Aus der JP 57 015444 A ist eine Versiegelung für elektronische Komponenten bekannt. Hierfür wird ein umgebendes Gehäuse mit einer ersten Materialmasse befüllt, in die eine elektronische Komponente eingepresst wird. Anschließend wird das Gehäuse vollständig mit einer zweiten Materialmasse aufgefüllt, sodass lediglich Anschlüsse der elektronischen Komponente aus dem Gehäuse und damit aus den die elektronische Komponente versiegelnden Materialmassen herausragen.

Außerdem ist aus der DE 10 2009 001373 A1 ein Verfahren zum Einbetten einer elektrischen Baugruppe in einen aus Formmasse zu bildenden Formkörper bekannt, wobei die Baugruppe in eine geöffnete Form eingebracht, die Form geschlossen und im Spritzpressverfahren ein Formmassenvolumen in die geschlossene Form eingebracht wird.

Die DE 10 2009 026804 A1 wiederum offenbart ein Verfahren zur Herstellung elektronsicher Bauteile, das die folgenden Schritte umfasst: Bereitstellen mehrerer Einlegeteile, die zusammen in einem Rahmen angeordnet sind, Bestücken der Einlegeteile mit jeweils zumindest einem elektronischen Mikrobauelement, wobei je ein Einlegeteil zusammen mit dem zumindest einen Mikrobauelement eine Einheit bildet, Umspritzen der Einheiten mit je einem separaten ersten Überzug um das zumindest eine Mikrobauelement auf zugehörigem Einlegeteil zu fixieren, Trennen der Einheiten aus dem Rahmen nach dem Umspritzen mit dem ersten Überzug und Umspritzen der Einheiten mit je einem zweiten Überzug.

Aus der WO 99/53740 A1 ist eine Verkapselung für elektronische Komponenten bekannt. Diese umfasst zwei Kammern, wobei die beiden Kammern mit unterschiedlichen Materialien gefüllt sein können, um die elektronischen Komponenten zu verkapseln.

Weiterhin ist aus der US 2006/0220202 A1 ein integrierter Schaltkreis bekannt, der in einem Gehäuse eingebettet ist. Dabei ist das Gehäuse aus duoplastischem Material gefertigt und weist einen Versiegelungsbereich auf, der den integrierten Schaltkreis versiegelt.

Die US 2006/0054901 A1 zeigt einen optischen Halbleiter, der auf einem Träger angebracht ist und der von insgesamt zwei Schichten zweier unterschiedlicher Moldmassen umgeben ist. Schließlich offenbart de US 2002/0063326 A1 eine elektronische Einheit, die einen Halbleiterchip sowie eine Vielzahl von externen Anschlüssen umfasst. Der Halbleiterchip wird dabei derart verkapselt, dass die Verbindungsanschlüsse auf der Unterseite der elektronischen Komponente unbedeckt bleiben.

### Offenbarung der Erfindung

Das erfindungsgemäße Verfahren zur Herstellung einer elektronischen Baugruppe mit wenigstens einem elektronischen Bauteil und einem das elektronische Bauteil zumindest teilweise umgebenden Formkörper mit den Merkmalen des Anspruchs 1 weist demgegenüber den Vorteil auf, dass zwei oder mehr verschiedene Moldmaterialien verwendet werden können, welche entsprechend spezifischen Anforderungen von verschiedenen elektronischen Bauteilen ausgewählt werden können. Dabei ist es insbesondere vorgesehen, dass das zumindest eine elektronische Bauelement zumindest teilweise, bevorzugt vollständig von dem ersten Moldmaterial umschlossen wird. Ferner ist bevorzugt vorgesehen, dass der nicht vom ersten Moldmaterial umschlossene Bereich des zumindest einen elektronischen Bauelements zumindest teilweise, bevorzugt vollständig von dem zweiten und/oder den weiteren Moldmaterialien umschlossen wird. Alternativ oder zusätzlich ist ebenso bevorzugt vorgesehen, dass ein weiteres elektronisches Bauelement zumindest teilweise, bevorzugt vollständig von dem zweiten und/oder den weiteren Moldmaterialien umschlossen wird. Mit "umschließen" ist insbesondere gemeint, dass das jeweilige Moldmaterial in unmittelbarem Kontakt zum jeweiligen elektronischen Bauelement steht. Durch die lokal verteilte Anordnung der zwei oder mehreren Molmaterialien zur Ausbildung eines Formkörpers ist sichergestellt, dass jedes elektronische Bauelement in Abhängigkeit seiner spezifischen Anforderung in Bezug auf z.B. Entwärmung, Ausdehnung, mechanische Belastung usw., von einem daraufhin abgestimmten Moldmaterial umgeben ist. Dabei bleibt das erfindungsgemäße Verfahren sehr wirtschaftlich und ist insbesondere auch für große Stückzahlen geeignet. Das erfindungsgemäße Verfahren umfasst dabei die Schritte des Einlegens eines oder mehrerer elektronischer Bauteile in ein geöffnetes Formwerkzeug, des Zuführens von wenigstens zwei verschiedenen Moldmaterialien in einen Hohlraum im Formwerkzeug und des Schließens des Formwerkzeugs. Dabei kann das Schließen des Formwerkzeugs vor oder gleichzeitig mit dem Zuführen der Moldmaterialien erfolgen. Es sei angemerkt, dass bei einem gleichzeitigen Schließen des Formwerkzeugs und des Zuführens der Moldmaterialien darauf geachtet werden muss, dass das Moldmaterial nicht aus dem Formwerkzeug austreten kann. Das elektronische Bauteil ist vorzugsweise eine Leiterplatte oder ein Stanzgitter oder ein Keramiksubstrat, auf welchem verschiedenste weitere elektronische Bauteile, z.B. Sensoren, Chips, ICs, Leistungstransistoren, Kondensatoren, Spulen, Widerstände, usw., angeordnet sein können. Das erfindungsgemäße Verfahren wird besonders bevorzugt zur Herstellung von Steuergeräten für Fahrzeuge oder anderer Elektronikbaugruppen für Fahrzeuge verwendet.

Die Unteransprüche zeigen bevorzugte Weiterbildungen der Erfindung.

Um eine besonders schnelle Befüllung des Formwerkzeugs mit den verschiedenen Moldmaterialien sicherzustellen, werden die Moldmaterialien vorzugsweise gleichzeitig zugeführt.

Besonders bevorzugt werden dabei das erste Moldmaterial mit einem ersten Presskolben und das zweite Moldmaterial mit einem zweiten Presskolben zugeführt.

Um eine Vermischung der Moldmaterialien zu vermeiden, sind vorzugsweise Trennelemente vorgesehen, welche an einem elektronischen Bauteil angelegt sind oder welche an einem elektronischen Bauteil fixiert sind, z.B. mittels Kleben oder Schweißen oder Löten, wobei die Trennelemente mit einer Werkzeugwand des Formwerkzeugs eine Unterteilung des im Formwerkzeug vorhandenen Hohlraums bereitstellen. Die Trennelemente bewirken somit eine Abdichtung an dem elektronischen Bauteil und der Werkzeugwand, so dass eine klar definierte Unterteilung der den Formkörper bildenden Moldmaterialien möglich ist. Auf diese Weise ist beispielsweise ein erstes elektronisches Bauelement von einem ersten Moldmodul vollständig bis zum Außenbereich des Formkörpers umschlossen, wobei das erste Moldmaterial an ein Trennelement angrenzt. Ferner ist beispielsweise ein weiteres elektronisches Bauelement von einem zweiten Moldmaterial bis zum Außenbereich des Formkörpers umschlossen. Dabei ist das zweite Moldmaterial durch das eine Trennelement von dem ersten Moldmaterial getrennt. Die Trennelemente sind vorzugsweise aus Kunststoff.

Gemäß einer weiteren bevorzugten Ausgestaltung der Erfindung sind Führungselemente zum Führen des zugeführten Moldmaterials im Hohlraum vorgesehen. Die Führungselemente können dabei am Formwerkzeug und/oder am elektronischen Bauteil und/oder als loses Einlegeteil vorgesehen sein. Die Führungselemente ermöglichen dabei eine Strömungsführung der zugeführten Moldmassen, so dass beispielsweise eine gezielte Vermischung von zwei Moldmaterialien in gewünschten Teilbereichen des Formkörpers möglich ist. Hierdurch ergibt sich eine weitere Möglichkeit durch Mischen von zwei reinen Moldmaterialien ein drittes Moldmaterial mit unterschiedlichen Eigenschaften während des Moldvorgangs herzustellen.

Für eine besonders schnelle und gleichmäßige Befüllung des Hohlraums des Formwerkzeugs werden das erste und zweite Moldmaterial vorzugsweise von einander gegenüber liegenden Seiten in das Formwerkzeug zugeführt.

Als Moldmaterial werden vorzugsweise Kunststoffe mit unterschiedlichen Werkstoffeigenschaften, insbesondere hinsichtlich ihrer Eigenelastizität, verwendet.

Die Erfindung betrifft ferner eine elektronische Baugruppe, wie beispielsweise ein elektronisches Steuergerät für Fahrzeuge, umfassend wenigstens ein elektronisches Bauteil, z.B. eine Leiterplatte mit verschiedenen Elektronikbauteilen (z.B. Chips), und einen das elektronische Bauteil zumindest teilweise umgebenden Formkörper. Der Formkörper ist dabei aus wenigstens zwei verschiedenen Moldmaterialien hergestellt. Dabei ist insbesondere das zumindest eine elektronische Bauelement zumindest teilweise, bevorzugt vollständig von dem ersten Moldmaterial umschlossen. Ferner ist der nicht vom ersten Moldmaterial umschlossene Bereich des zumindest einen elektronischen Bauelements zumindest teilweise, bevorzugt vollständig, von dem zweiten und/oder den weiteren Moldmaterialien umschlossen. Alternativ oder zusätzlich ist bevorzugt ein weiteres elektronisches Bauelement zumindest teilweise, bevorzugt vollständig, von dem zweiten und/oder den weiteren Moldmaterialien umschlossen. Hierdurch kann eine individuelle Anpassung durch Auswahl der jeweiligen Moldmaterialien auf die spezifischen Gegebenheiten der verschiedenen elektronischen Bauteile ausgeführt werden.

Vorzugsweise umfasst die erfindungsgemäße elektronische Baugruppe ferner wenigstens ein Trennelement, welches im Formkörper angeordnet ist und das erste Moldmaterial vom zweiten Moldmaterial trennt. Hierdurch ist eine exakte Trennung zwischen den beiden Moldmaterialien ohne eine Vermischung der Moldmaterialien möglich. Besonders bevorzugt ist das Trennelement direkt an einem elektronischen Bauteil angeordnet oder alternativ ist das Trennelement direkt das elektronische Bauteil selbst.

Gemäß einer weiteren bevorzugten Ausgestaltung der Erfindung umfasst die erfindungsgemäße elektronische Baugruppe vorzugsweise wenigstens ein Führungselement, welches im Formkörper angeordnet ist. Das Führungselement dient bei der Herstellung des Formkörpers zur Strömungsführung des zugeführten Moldmaterials. Das Führungselement kann dabei einerseits die Führung des Moldmaterials im Formwerkzeug definieren und andererseits auch eine gezielte Vermischung von zwei verschiedenen Moldmaterialien durch entsprechende Führung der Materialströme ermöglichen. Das Führungselement ist vorzugsweise aus Kunststoff hergestellt.

### Zeichnung

Nachfolgend werden bevorzugte Ausführungsbeispiele der Erfindung unter Bezugnahme auf die begleitende Zeichnung im Detail beschrieben. In der Zeichnung ist:
- Figur 1: eine schematische Schnittansicht einer elektronischen Baugruppe gemäß einem ersten Ausführungsbeispiel der Erfindung,
- Figur 2: eine schematische Schnittansicht eines Werkzeugaufbaues zur Herstellung der Baugruppe von Figur 1,
- Figur 3: eine schematische Draufsicht auf ein Formwerkzeug zur Herstellung einer elektronischen Baugruppe gemäß einem zweiten Ausführungsbeispiel der Erfindung mit eingelegtem elektronischen Bauteil,
- Figur 4: eine schematische Schnittansicht entlang der Linie III-III von Figur 3,
- Figur 5: eine schematische Draufsicht entsprechend Figur 3 mit Darstellung der Zuführung von Moldmaterialien, und
- Figur 6: eine schematische Schnittansicht entlang der Linie VI-VI von Figur 5.

### Bevorzugte Ausführungsformen der Erfindung

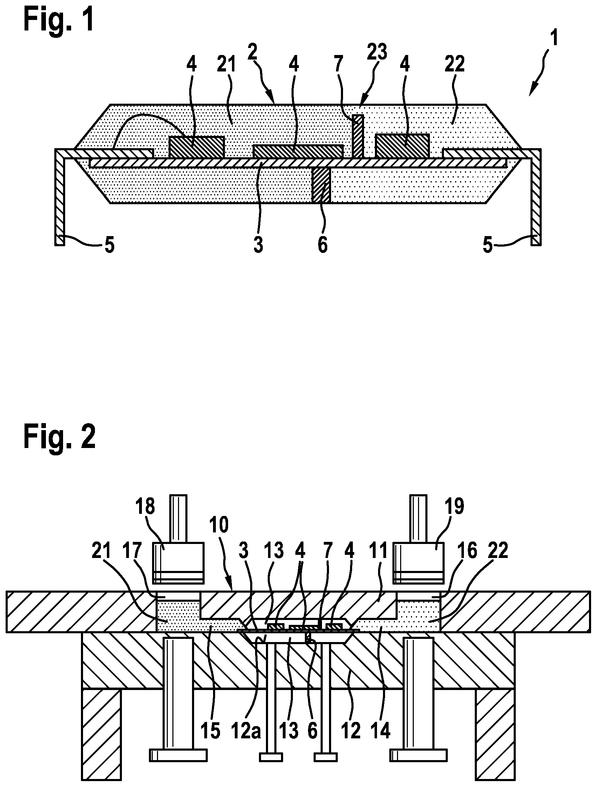

Nachfolgend wird unter Bezugnahme auf die Figuren 1 und 2 ein Verfahren sowie eine elektronische Baugruppe 1 gemäß einem ersten bevorzugten Ausführungsbeispiel der Erfindung im Detail beschrieben.

Wie aus Figur 1 ersichtlich ist, umfasst die elektronische Baugruppe einen Formkörper 2 sowie eine Vielzahl von elektronischen Bauteilen, insbesondere eine Leiterplatte 3 und eine Vielzahl von auf der Leiterplatte angeordneten Elektronikelementen 4. Ferner sind zwei Leitungsanschlüsse 5 aus dem elektronischen Bauteil 1 herausgeführt.

Der Formkörper 2 des ersten Ausführungsbeispiels ist aus einem ersten Moldmaterial 21 und einem zweiten Moldmaterial 22 hergestellt. Die Moldmaterialien sind beispielsweise verschiedene Kunststoffe mit unterschiedlichen elastischen Eigenschaften. Ferner umfasst die elektronische Baugruppe 1 ein aus Kunststoff hergestelltes Trennelement 6, welches die Leiterplatte 3 berührt, bis zur Außenseite des Formkörpers 2 vorsteht und eine exakte Trennung zwischen dem ersten Moldmaterial 21 und dem zweiten Moldmaterial 22 bereitstellt.

Weiterhin ist ein Führungselement 7 vorgesehen, welches an der Leiterplatte 2 angeordnet ist, jedoch nicht bis zur Außenfläche des Formkörpers vorsteht. Das Führungselement 7 dient zur Führung der zugeführten, strömenden Moldmaterialien. Dabei ergibt sich an der zur Oberfläche des Formkörpers 2 gerichteten Seite ein Mischbereich 23, in welchem eine Vermischung des ersten und zweiten Moldmaterials auftritt. Je nach Ausgestaltung des Führungselements 7 kann diese Vermischung der beiden Moldmaterialien 21 und 22 stärker oder schwächer ausgeprägt sein. Somit kann durch das Führungselement 7 durch Vermischung des ersten und zweiten Moldmaterials ein drittes Moldmaterial mit unterschiedlichen Eigenschaften während des Moldvorgangs bereitgestellt werden.

Insgesamt ist in diesem konkreten Beispiel ein Bereich der Unterseite der Leiterplatte 3 bis zum Trennelement 3 und bis zur unteren Außenfläche des Förmkörpers 2, sowie ein Bereich von der Oberseite der Leiterplatte 3 zusammen mit zwei elektronischen Bauelementen 4 bis zum Führungselement 7 bzw. Mischbereich 23 und bis zur oberen Außenfläche des Formkörpers 2 vom ersten Moldmaterial 21umschlossen. Ferner ist ein weiterer Bereich der Unterseite der Leiterplatte 3 ausgehend vom Trennelement 3 bis zur unteren Außenfläche des Förmkörpers 2, sowie ein Bereich von der Oberseite der Leiterplatte 3 zusammen mit zwei elektronischen Bauelementen 4 ausgehende vom Führungselement 7 bzw. Mischbereich 23 bis zur oberen Außenfläche des Formkörpers 2 vom zweiten Moldmaterial 22 umschlossen

Figur 2 verdeutlicht die Herstellung der elektronischen Baugruppe 1. Wie aus der Darstellung von Figur 2 ersichtlich ist, ist eine mit Elektronikelementen 4 bestückte Leiterplatte 3 in einen Hohlraum 13 des Formwerkzeugs 10 eingelegt, welcher zwischen einer ersten Formwerkzeughälfte 11 und einer zweiten Formwerkzeughälfte 12 vorhanden ist. Über Kanäle 14, 15 wird das erste und zweite Moldmaterial 21, 22 aus einem Vorratsraum 16, 17 mittels Kolben 18, 19 in den Hohlraum 13 zugeführt.

Das Trennelement 6 kann dabei als Einlegeteil zwischen die Leiterplatte 3 und eine Werkzeugwand 12a eingelegt sein oder das Trennelement 6 ist an der Leiterplatte 3 oder an der zweiten Formwerkzeughälfte 12 fest vorgesehen. Das Führungselement 7 kann ebenfalls als Einlegeteil vorgesehen sein oder das Führungselement 7 ist alternativ an der Leiterplatte 3 fixiert, beispielsweise mittels Kleben.

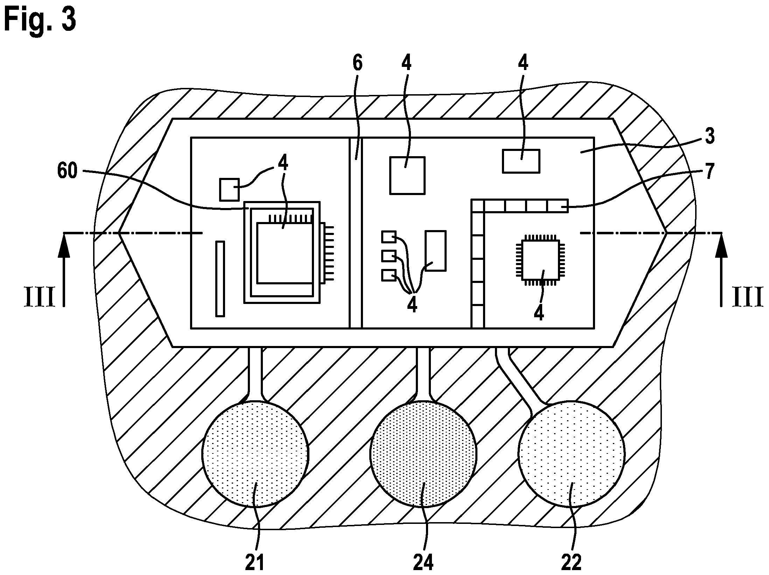

Das erfindungsgemäße Verfahren kann dabei derart ausgeführt werden, dass zuerst die beiden Formwerkzeughälften 11, 12 geschlossen werden und dann das erste und zweite Moldmaterial 21, 22 in den Hohlraum 13 zugeführt wird. Alternativ können gleichzeitig mit dem Beginn des Schließvorgangs der beiden Formwerkzeughälften 11, 12 auch die beiden Kolben 18, 19 bewegt werden und so mit dem Zuführen des ersten und zweiten Moldmaterials 21, 22 in den Hohlraum 13 gleichzeitig mit dem Beginn des Schließvorgangs des Formwerkzeugs 10 begonnen werden. Bei letzterer Alternative ist lediglich darauf zu achten, dass das schon vor dem vollständigen Schließen des Formwerkzeugs zugeführte Moldmaterial nicht über die Grenzen des Hohlraums hinaustritt. Nachfolgend wird unter Bezugnahme auf die Figuren 3 bis 6 ein elektronisches Bauteil und ein Verfahren zu dessen Herstellung gemäß einem zweiten Ausführungsbeispiel der Erfindung beschrieben, wobei gleiche bzw. funktional gleiche Teile mit den gleichen Bezugszeichen wie im ersten Ausführungsbeispiel bezeichnet sind.

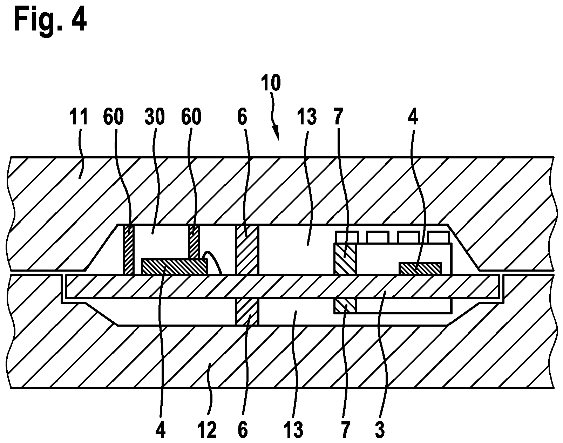

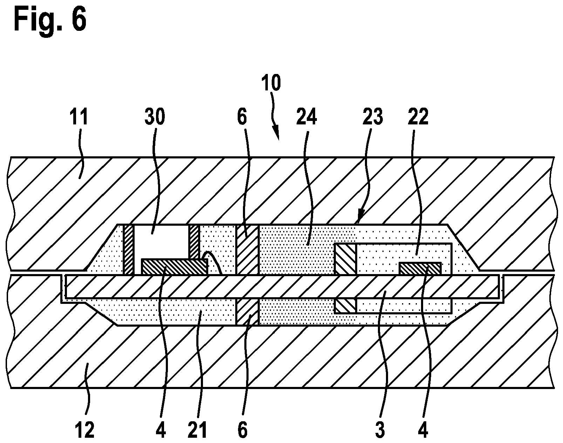

Das zweite Ausführungsbeispiel zeigt eine elektronische Baugruppe sowie ein Verfahren, bei dem zusätzlich noch ein drittes Moldmaterial 23 verwendet wird. Somit weist die derart hergestellte elektronische Baugruppe einen Formkörper mit drei unterschiedlichen Eigenschaften entsprechend den Materialeigenschaften der drei Moldmaterialien auf. Die Figuren 3 und 4 zeigen dabei den Zustand, bei dem die elektronischen Bauteile wie die Leiterplatte 3 und Chips 4 in das Werkzeug 10 eingelegt sind. Hierdurch entstehen oberhalb und unterhalb der Leiterplatte 3 Hohlräume 13, die am Außenumfang miteinander verbunden sind. In der Leiterplatte 3 ist ferner ein Trennelement 6 angeordnet, welches in diesem Ausführungsbeispiel an einer Oberseite und einer Unterseite der Leiterplatte 3 vorgesehen ist. Ferner ist ein drittes, umlaufend geschlossenes Trennelement 60 an der Leiterplatte 3 bzw. einem Chip 4 angeordnet, welches einen Teilbereich des Chips 4 überdeckt. Hierdurch entsteht ein weiterer Hohlraum 30. Da das dritte Trennelement 60 rundum geschlossen ist, ergibt sich im späteren Bauteil, wie aus Figur 6 ersichtlich ist, ein verbleibender Hohlraum 30, welcher nicht mit Moldmaterial gefüllt ist.

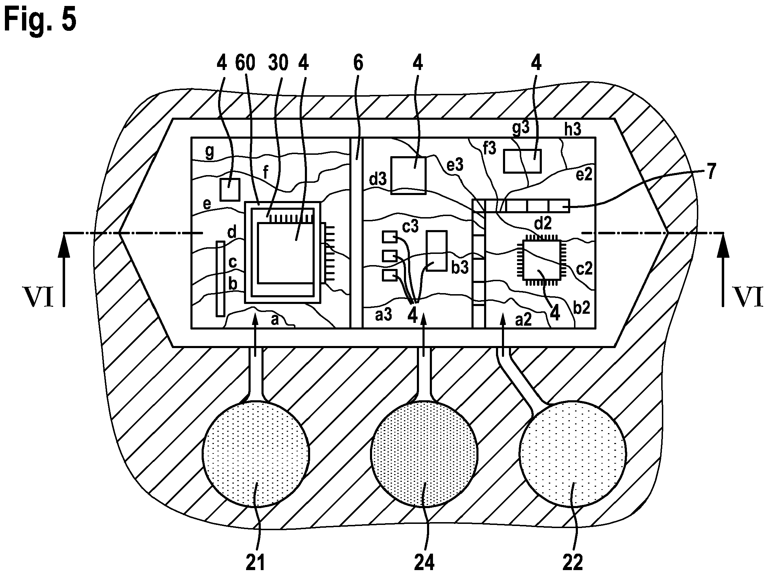

Ferner ist ein Führungselement 7 vorgesehen, welches, wie insbesondere aus Figur 3 ersichtlich ist, eine zinnenartige Kronenform aufweist. Hierdurch ist es möglich, dass das zweite Moldmaterial 22 und das dritte Moldmaterial 24 sich im Bereich des Führungselements 7 teilweise vermischen. Das Führungselement 7 beeinflusst insbesondere die Formkörpermassen-Fließfront, auch im Zusammenspiel mit der Positionierung der Ausgussöffnungen für die Moldmaterialien. In Figur 5 sind durch dünne Strichlinien jeweils die Fließlinien bei der Befüllung der Kavität 13 dargestellt. Für das erste Moldmaterial 21 sind insgesamt sieben Fließlinien a, b, c, d, e, f, g eingezeichnet. Für das zweite Moldmaterial 22 sind fünf Fließlinien a2, b2, c2, d2 und e2 eingezeichnet. Für das dritte Moldmaterial 24 sind acht Fließlinien a3, b3, c3, d3, e3, f3, g3 und h3 eingezeichnet. Durch die in Draufsicht winkelförmige Form des Führungselements 7 kann sichergestellt werden, dass das zweite Moldmaterial 22 den Bereich zwischen der Ausgussöffnung und dem Führungselement 7 auffüllt, wobei es im Bereich der Zinnen des Führungselements 7 zu einer Vermischung mit dem dritten Moldmaterial 24 kommt. Ansonsten entspricht dieses Ausführungsbeispiel dem vorherigen Ausführungsbeispiel, so dass auf die Beschreibung verwiesen werden kann.

Erfindungsgemäß wird, wie in den beiden Ausführungsbeispielen beschrieben, somit ein Verfahren zur Herstellung einer elektronischen Baugruppe bereitgestellt, welche aus mehreren Moldmaterialien hergestellt ist. Hierbei kann auf spezifische Eigenschaften von einzelnen elektronischen Bauteilen durch Materialwahl und/oder Anordnung von Trennelementen 6, insbesondere vollständig geschlossenen Trennelementen, zur Erzeugung moldmassenfreier Bereiche, und/oder Verwendung von Führungselementen 7 ein spezifischer Formkörper 2 hergestellt werden. Dabei ist sowohl eine teilweise Einbettung elektronischer Bauteile als auch eine vollständige Einkapselung möglich. Die Erfindung wird besonders bevorzugt in Verbindung mit elektronischen Baugruppen für Fahrzeuge, beispielsweise Steuergeräten, Sensoren usw. verwendet.

## Patentansprüche

1. Verfahren zur Herstellung einer elektronischen Baugruppe (1), die vollständig von mindestens zwei Moldmaterialien umschlossen ist und bei der elektrische Kontaktelemente bis zu einer Außenseite eines aus den Moldmaterialien ausgebildeten Formkörpers (2) geführt sind, mit wenigstens einem elektronischen Bauteil (3, 4), umfassend die Schritte:
- Einlegen wenigstens eines elektronischen Bauteils (3, 4) in eine geöffnetes Formwerkzeug (10), wobei das wenigstens eine elektronische Bauteil (3, 4) eine Leiterplatte, ein Stanzgitter oder ein Keramiksubstrat mit einer Ober- und einer Unterseite ist,
- Anordnen eines Trennelements (6) im Formwerkzeug (10), wobei das Trennelement einerseits an das elektronische Bauteil (3, 4) angelegt ist oder am elektronischen Bauteil (3, 4) fixiert ist und andererseits bis an eine Werkzeugwand des Formwerkzeuges reicht, und / oder
- Anordnen wenigstens eines Führungselements (7) im Formwerkzeug (10),
- Zuführen zumindest eines ersten Moldmaterials (21) und eines zweiten Moldmaterials (22) in einen Hohlraum (13) im Formwerkzeug (10), wobei das erste Moldmaterial unterschiedlich zum zweiten Moldmaterial ist,
- wobei durch das Trennelement (6) eine Unterteilung des in dem Formwerkzeug vorhandenen Hohlraums bereitgestellt wird und das erste Moldmaterial (21) und das zweite Moldmaterial (22) in einem Bereich zwischen der Oberseite der Leiterplatte, des Stanzgitters oder des Keramiksubstrats und der Werkzeugwand und/oder zwischen der Unterseite der Leiterplatte, des Stanzgitters oder des Keramiksubstrats und der Werkzeugwand voneinander trennt, wobei das Trennelement (6) eine Abdichtung an dem elektronischen Bauteil (3, 4) und der Werkzeugwand bewirkt, und/oder
- wobei durch das Führungselement eine Strömungsführung des zugeführten ersten und zweiten Moldmaterials ermöglicht wird, so dass in definierten Teilbereichen des Formkörpers ein Mischbereich durch Vermischen des ersten und des zweiten Moldmaterials ausgebildet wird, und
- Schließen des Formwerkzeugs (10),
- wobei das Schließen des Formwerkzeugs (10) vor oder gleichzeitig mit dem Zuführen des ersten und zweiten Moldmaterials (21, 22) erfolgt,

2. Verfahren nach Anspruch 1, **dadurch gekennzeichnet, dass** das erste und zweite Moldmaterial (21, 22) gleichzeitig zugeführt wird.

3. Verfahren nach einem der vorhergehenden Ansprüche, **dadurch gekennzeichnet, dass** das erste Moldmaterial (21) mit einem ersten Kolben (18) und das zweite Moldmaterial (22) mit einem zweiten Kolben (19) zugeführt wird.

4. Verfahren nach einem der vorhergehenden Ansprüche, **dadurch gekennzeichnet, dass** das erste und zweite Moldmaterial (21, 22) voneinander gegenüberliegenden Seiten in das Werkzeug (10) zugeführt werden.

5. Elektronische Baugruppe, umfassend wenigstens ein elektronisches Bauteil (3, 4), wobei das wenigstens eine Bauteil (3, 4) eine Leiterplatte, ein Stanzgitter oder ein Keramiksubstrat mit einer Ober- und einer Unterseite ist, wobei die elektronische Baugruppe vollständig von mindestens einem ersten und einem zweiten Moldmaterial (21, 22) umschlossen ist und bei der elektrische Kontaktelemente bis zu einer Außenseite eines aus den Moldmaterialien ausgebildeten Formkörpers (2) geführt sind, wobei das erste Moldmaterial (21) unterschiedlich zum zweiten Moldmaterial (22) ist, wobei im Formkörper (2) ein Trennelement (6) angeordnet ist, das einerseits an das elektronische Bauteil (3, 4) angelegt ist oder am elektronischen Bauteil (3, 4) fixiert ist und andererseits bis an eine Außenfläche des Formkörpers (2) reicht, und/oder ein Führungselement (7) vorgesehen ist, wobei das Trennelement (6) das erste Moldmaterial (21) und das zweite Moldmaterial (22) in einem Bereich zwischen der Oberseite der Leiterplatte, des Stanzgitters oder des Keramiksubstrates und der Außenfläche des Formkörpers (2) und/oder zwischen der Unterseite der Leiterplatte, des Stanzgitters oder des Keramiksubstrates und der Außenfläche des Formkörpers (2) voneinander trennt, und/oder in definierten Teilbereichen des Formkörpers (2) aufgrund einer entsprechenden Strömungsführung des zugeführten ersten und zweiten Moldmaterials (21, 22) durch das Führungselement ein Mischbereich durch Vermischen des ersten und des zweiten Moldmaterials ausgebildet ist.

6. Elektronische Baugruppe nach Anspruch 5, **dadurch gekennzeichnet, dass** das Trennelement ein elektronisches Bauteil ist oder dass das Trennelement (6) umlaufend geschlossen ausgebildet ist, um im Formkörper (2) einen Hohlraum (30) zu bilden.

7. Elektronische Baugruppe nach einem der Ansprüche 5 oder 6, **dadurch gekennzeichnet, dass** die elektronische Baugruppe weitere elektronische Bauteile umfasst, welche auf der Leiterplatte, dem Stanzgitter oder dem Keramiksubstrat angeordnet sind.

8. Elektronische Baugruppe nach einem der Ansprüche 5 bis 7, **dadurch gekennzeichnet, dass** das wenigstens eine elektronisches Bauteil von dem ersten Moldmaterial vollständig bis zur Außenfläche des Formkörpers umschlossen ist und zumindest ein zweites elektronisches Bauteil von dem zweiten Moldmaterial vollständig bis zur Außenfläche des Formkörpers umschlossen ist.

## Claims

1. Method for producing an electronic assembly (1) which is completely surrounded by at least two moulding materials and in the case of which electric contact elements are led as far as an outside of a shaped body (2) formed from the moulding materials, having at least one electronic component (3, 4), comprising the steps:
- inserting at least one electronic component (3, 4) into an opened mould (10), the at least one electronic component (3, 4) being a printed circuit board, a lead frame or a ceramic substrate with an upper side and an underside,
- arranging a separating element (6) in the mould (10), the separating element being placed against the electronic component (3, 4) or being fixed to the electronic component (3, 4) at one end and extending as far as a wall of the mould at the other end, and/or
- arranging at least one guide element (7) in the mould (10),
- supplying at least a first moulding material (21) and a second moulding material (22) to a cavity (13) in the mould (10), the first moulding material being different from the second moulding material,
- the separating element (6) providing a subdivision of the cavity in the mould and separates the first moulding material (21) and the second moulding material (22) from one another in a region between the upper side of the printed circuit board, the lead frame or the ceramic substrate and the mould wall and/or between the underside of the printed circuit board, the lead frame or the ceramic substrate and the mould wall, the separating element (6) effecting sealing on the electronic component (3, 4) and the mould wall, and/or
- the guide element permitting flow guidance of the first and second moulding material supplied, so that by mixing the first and second moulding material a mixing area is formed in defined subareas of the shaped body, and
- closing the mould (10),
- the mould (10) being closed before or at the same time as the first and second moulding material (21, 22) are supplied.

2. Method according to Claim 1, **characterized in that** the first and second moulding material (21, 22) are supplied simultaneously.

3. Method according to either of the preceding claims, **characterized in that** the first moulding material (21) is supplied by a first piston (18) and the second moulding material (22) is supplied by a second piston (19).

4. Method according to one of the preceding claims, **characterized in that** the first and second moulding material (21, 22) are supplied to the mould (10) from mutually opposite sides.

5. Electronic assembly comprising at least one electronic component (3, 4), the at least one component (3, 4) being a printed circuit board, a lead frame or a ceramic substrate with an upper side and an underside, the electronic assembly being completely surrounded by at least one first and one second moulding material (21, 22) and in the case of which electric contact elements and led as far as an outside of a shaped body (2) formed from the moulding materials, the first moulding material (21) being different from the second moulding material (22), a separating element (6) being arranged in the shaped body (2) and being placed against the electronic component (3, 4) or being fixed to the electronic component (3, 4) at one end and extending as far as an outer surface of the shaped body (2) at the other end, and/or a guide element (7) being provided, the separating element (6) separating the first moulding material (21) and the second moulding material (22) from one another in a region between the upper side of the printed circuit board, the lead frame or the semantic substrate and the outer surface of the shaped body (2) and/or between the underside of the printed circuit board, the lead frame or the ceramic substrate and the outer surface of the shaped body (2), and/or by mixing the first and the second moulding material the guide element forming a mixing area in defined subareas of the shaped body (2) owing to corresponding flow guidance of the first and second moulding material (21, 22) supplied.

6. Electronic assembly according to Claim 5, **characterized in that** the separating element is an electronic component or **in that** the separating element (6) is circumferentially closed, in order to form a cavity (30) in the shaped body (2).

7. Electronic assembly according to either of Claims 5 and 6, **characterized in that** the electronic assembly comprises further electronic components which are arranged on the printed circuit board, the lead frame or the ceramic substrate.

8. Electronic assembly according to one of Claims 5 to 7, **characterized in that** the at least one electronic component is completely surrounded by the first moulding material as far as the outer surface of the shaped body and at least a second electronic component is completely surrounded by the second moulding material as far as the outer surface of the shaped body.

## Revendications

1. Procédé de fabrication d'un sous-ensemble électronique (1), qui est entièrement entouré d'au moins deux matériaux de moulage et avec lequel des éléments de contact électriques sont acheminés jusqu'à un côté extérieur d'un corps moulé (2) formé à partir des matériaux de moulage, pourvu d'au moins un composant électronique (3, 4), comprenant les étapes suivantes :
- introduction d'au moins un composant électronique (3, 4) dans un outil de moulage (10) ouvert, l'au moins un composant électronique (3, 4) étant un circuit imprimé, une grille estampée ou un substrat en céramique ayant un côté supérieur et un côté inférieur,
- disposition d'un élément de séparation (6) dans l'outil de moulage (10), l'élément de séparation étant d'un côté appliqué contre le composant électronique (3, 4) ou fixé au composant électronique (3, 4) et, de l'autre côté, s'étendant jusqu'à une paroi d'outil de l'outil de moulage, et/ou
- disposition d'au moins un élément de guidage (7) dans l'outil de moulage (10),
- acheminement d'au moins un premier matériau de moulage (21) et d'un deuxième matériau de moulage (22) dans un espace creux (13) dans l'outil de moulage (10), le premier matériau de moulage étant différent du deuxième matériau de moulage,
- une subdivision de l'espace creux présent dans l'outil de moulage étant produit par l'élément de séparation (6) et sépare le premier matériau de moulage (21) et le deuxième matériau de moulage (22) l'un de l'autre dans une zone entre le côté supérieur du circuit imprimé, de la grille estampée ou du substrat en céramique et la paroi d'outil et/ou entre le côté inférieur du circuit imprimé, de la grille estampée ou du substrat en céramique et la paroi d'outil, l'élément de séparation (6) produisant une étanchéification au niveau du composant électronique (3, 4) et de la paroi d'outil, et/ou
- l'élément de guidage rendant possible un guidage de l'écoulement du premier et du deuxième matériau de moulage acheminés, de sorte qu'une zone de mélange est formée dans des zones partielles définies du corps moulé par mélange du premier et du deuxième matériau de moulage et
- fermeture de l'outil de moulage (10),
- la fermeture de l'outil de moulage (10) s'effectuant avant l'acheminement du premier et du deuxième matériau de moulage (21, 22) ou simultanément avec celui-ci.

2. Procédé selon la revendication 1, **caractérisé en ce que** le premier et le deuxième matériau de moulage (21, 22) sont acheminés simultanément.

3. Procédé selon l'une des revendications précédentes, **caractérisé en ce que** le premier matériau de moulage (21) et acheminé avec un premier piston (18) et le deuxième matériau de moulage (22) avec un deuxième piston (19).

4. Procédé selon l'une des revendications précédentes, **caractérisé en ce que** le premier et le deuxième matériau de moulage (21, 22) sont acheminés dans l'outil (10) par des côtés opposés l'un de l'autre.

5. Sous-ensemble électronique, comprenant au moins un composant électronique (3, 4), l'au moins un composant (3, 4) étant un circuit imprimé, une grille estampée ou un substrat en céramique ayant un côté supérieur et un côté inférieur, le sous-ensemble électronique étant entièrement entouré d'au moins un premier et un deuxième matériau de moulage (21, 22) et avec lequel des éléments de contact électriques étant acheminés jusqu'à un côté extérieur d'un corps moulé (2) formé à partir des matériaux de moulage, le premier matériau de moulage (21) étant différent du deuxième matériau de moulage (22), un élément de séparation (6) étant disposé dans le corps moulé (2), lequel est d'un côté appliqué contre le composant électronique (3, 4) ou fixé au composant électronique (3, 4) et, de l'autre côté, s'étendant jusqu'à une surface extérieure du corps moulé (2), et/ou un élément de guidage (7) étant présent, l'élément de séparation (6) séparant le premier matériau de moulage (21) et le deuxième matériau de moulage (22) l'un de l'autre dans une zone entre le côté supérieur du circuit imprimé, de la grille estampée ou du substrat en céramique et la surface extérieure du corps moulé (2) et/ou entre le côté inférieur du circuit imprimé, de la grille estampée ou du substrat en céramique et la surface extérieure du corps moulé (2), et/ou dans des zones partielles définies du corps moulé (2), du fait d'un guidage en conséquence de l'écoulement du premier et du deuxième matériau de moulage (21, 22) acheminés par l'élément de guidage, une zone de mélange est formée par mélange du premier et du deuxième matériau de moulage.

6. Sous-ensemble électronique selon la revendication 5, **caractérisé en ce que** l'élément de séparation est un composant électronique ou **en ce que** l'élément de séparation (6) est de configuration fermée sur son pourtour afin de former un espace creux (30) dans le corps moulé (2).

7. Sous-ensemble électronique selon l'une des revendications 5 ou 6, **caractérisé en ce que** le sous-ensemble électronique comprend des composants électroniques supplémentaires qui sont disposés sur le circuit imprimé, la grille estampée ou le substrat en céramique.

8. Sous-ensemble électronique selon l'une des revendications 5 à 7, **caractérisé en ce que** l'au moins un composant électronique est entièrement entouré par le premier matériau de moulage jusqu'à la surface extérieure du corps moulé et au moins un deuxième composant électronique est entièrement entouré par le deuxième matériau de moulage jusqu'à la surface extérieure du corps moulé.
